Europäisches Patentamt

European Patent Office

Office européen des brevets

(19)

(11) Veröffentlichungsnummer: **0 456 119 A1**

# (12) EUROPÄISCHE PATENTANMELDUNG

(21) Anmeldenummer: 91107150.4

(22) Anmeldetag: 03.05.91

(51) Int. Cl.5: **C22F 1/10, C22C 32/00,** C22C 19/05

(30) Priorität: 07.05.90 DE 4014614

(43) Veröffentlichungstag der Anmeldung:
**13.11.91 Patentblatt 91/46**

(84) Benannte Vertragsstaaten:
**DE GB IT SE**

(71) Anmelder: **PM HOCHTEMPERATUR-METALL GmbH**
**Reuterweg 14**
**W-6000 Frankfurt/Main 1(DE)**

(72) Erfinder: **Zöltzer, Klaus Dr.**
**Ringstrasse 13**
**W-6362 Wöllstadt 1(DE)**
Erfinder: **Lempenauer, Klaus**
**Mühlstrasse 14**
**W-7000 Stuttgart 30(DE)**
Erfinder: **Fischmeister, Hellmut, Prof.Dr.**
**Birkendorfle 20**
**W-7000 Stuttgart 1(DE)**

(74) Vertreter: **Rieger, Harald, Dr.**
**Reuterweg 14**
**W-6000 Frankfurt a.M.(DE)**

(54) **Superlegierung auf Nickelbasis.**

(57) Bei aus Superlegierungen auf Nickelbasis hergestellten Profilen und Formkörpern mit aus stengelförmigen Körnern gebildetem Gefüge ist zur Erzielung einer vollkommenen Rekristallisation die maximale Aufheizgeschwindigkeit $\dot{T}_{max}$ von dem Verhältnis V eines oder mehrerer der Metallcarbid-Bildner Hafnium, Niob, Tantal, Titan und Zirkonium zu einem oder beiden der Metallcarbid-Bildner Wolfram und Molybdän abhängig.

Die Erfindung betrifft eine Superlegierung auf Nickelbasis zur Herstellung von Profilen und Formkörpern mit einem durch Wärmebehandlung erzeugten, aus stengelförmigen Körnern gebildeten Grobgefüge.

Bekanntlich werden aus z.B. durch mechanisches Legieren hergestellten Pulvern von Superlegierungen auf Nickelbasis auf pulvermetallurgischem Wege durch Strangpressen, Heißpressen oder Heißschmieden unter Vakuum oder Schutzgas Profile und Formkörper hergestellt und anschließend einer Wärmebehandlung zum Zwecke der Rekristallisation unterworfen. Dabei entstehen grobe, vorzugsweise stengelförmige Körner, in deren Längsrichtung die Profile bzw. Formkörper höchste mechanische Beanspruchbarkeit besitzen. Gemäß der EP-A-0 232 474 werden die Profile bzw. Formkörper in Umformrichtung mit einer Geschwindigkeit von bis zu 240 mm/h durch die Induktionsspule einer Heizeinrichtung geführt, wobei der axiale Temperatur/Weg-Gradient 7 bis 20° C/mm und die Temperatur 1150 bis 1350° C betragen. Durch dieses sogenannte Zonenglühen entsteht eine senkrecht zum axialen Temperatur/Weg-Gradienten sich bildende Rekristallisationsfront, hinter der in Umformrichtung liegende, längsgerichtete grobe stengelförmige Körner vorliegen.

Eine erfolgreiche Rekristallisation hängt sowohl von der Zusammensetzung der Superlegierungen auf Nickelbasis als auch von ihrer thermo-mechanischen Behandlung, d.h. von Umformgrad, Umformtemperatur und Umformgeschwindigkeit ab. Für bestimmte Legierungszusammensetzungen sind demnach feste legierungsabhängige Umformparameter einzuhalten, um eine sichere Rekristallisation zu erzielen.

Es hat sich jedoch in einer Reihe von Anwendungsfällen herausgestellt, daß trotz genauer Einhaltung der Umformparameter nur eine unvollkommene Rekristallisation der Profile und Formkörper aus Superlegierungen auf Nickelbasis erzielt werden konnte. Diese unvollkommene Rekristallisation liegt in der Aufheizgeschwindigkeit $\dot{T}$ (K/min) bis zur Rekristallisationstemperatur begründet, wobei eine besimmte minimale Aufheizgeschwindigkeit $\dot{T}_{min}$ unterschritten oder eine bestimmte maximale Aufheizgeschwindigkeit $\dot{T}_{max}$ überschritten wird.

Es ist die Aufgabe der vorliegenden Erfindung, eine Möglichkeit aufzuzeigen, die unabhängig von den vorstehend angeführten Umformparametern eine sichere Rekristallisation von Superlegierungen auf Nickelbasis gestattet.

Die Lösung dieser Aufgabe besteht darin, daß die maximale Aufheizgeschwindigkeit $\dot{T}_{max}$ bis zur Rekristallisationstemperatur von dem Verhältnis V eines oder mehrerer der Metallcarbid-Bildner (MC-Bildner) Hafnium, Niob, Tantal, Titan und Zirkonium zu einem oder beiden der Metallcarbid-Bildner ($M_{23}C_6$-Bildner) Molybdän und Wolfram abhängig ist, wobei mit steigendem Verhältnis V die maximale Aufheizgeschwindigkeit $\dot{T}_{max}$ zunimmt. Prinzipiell ist es ausreichend, wenn die Superlegierung auf Nickelbasis einen MC-Bildner enthält.

Eine vorzugsweise Ausbildung der Erfindung besteht darin, daß das Verhältnis V von MC-Bildnern zu $M_{23}C_6$-Bildnern

$$\frac{2,4\ \text{Hf} + 1,4\ \text{Nb} + 1,3\ \text{Ta} + 1,0\ \text{Ti} + 0,5\ \text{Zr (At.-\%)}}{\text{Mo} + \text{W (At.-\%)}} \geq 0,4$$

ist.

Vorzugsweise beträgt das Verhältnis V von MC-Bildnern zu $M_{23}C_6$-Bildnern $\geq 0,8$.

Die Superlegierung besitzt im Rahmen der Ausgestaltung der Erfindung die Zusammensetzung

```
12    bis  25,   vorzugsweise  17     bis  22    Gew.-% Cr
3     bis  8,    vorzugsweise  4,5    bis  7     Gew.-% Al
0     bis  0,1,  vorzugsweise  0,005  bis  0,05  Gew.-% B
0,01  bis  0,1,  vorzugsweise  0,02   bis  0,07  Gew.-% C
0     bis  2,    vorzugsweise  0,5    bis  1,5   Gew.-% Y₂O₃
0     bis  3,    vorzugsweise  0,2    bis  2     Gew.-% Hf
0     bis  7,    vorzugsweise  0,5    bis  5     Gew.-% Nb
0     bis  10,   vorzugsweise  1      bis  6,5   Gew.-% Ta
0     bis  5,    vorzugsweise  0,5    bis  3,5   Gew.-% Ti
0     bis  1,    vorzugsweise  0,02   bis  0,3   Gew.-% Zr
0     bis  10,   vorzugsweise  2      bis  6     Gew.-% Mo
0     bis  7,    vorzugsweise  1,5    bis  5     Gew.-% W
                                            Rest Ni.
```

Der mit der Erfindung erzielte Vorteil ist insbesondere darin zu sehen, daß durch die Einstellbarkeit eines optimalen Verhältnisses V zwischen den MC-Bildnern und den $M_{23}C_6$-Bildnern die maximale Aufheizgeschwindigkeit $\dot{T}_{max}$ nach oben verschoben, das $\dot{T}_{min}$-$\dot{T}_{max}$-Fenster vergrößert und damit die Rekristallisation erleichtert werden kann.

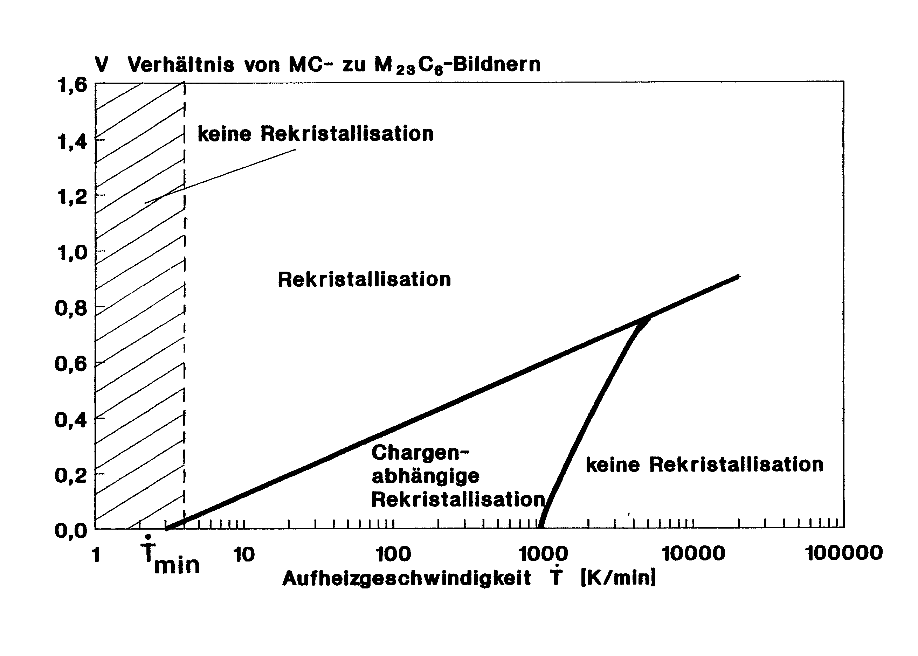

Die Erfindung ist in der Zeichnung in einem halblogarithmisch geteilten Koordinatensystem, das die Kurve der Abhängigkeit der maximalen Aufheizgeschwindigkeit $\dot{T}_{max}$ von dem Verhältnis V der MC-Bildner zu den $M_{23}C_6$-Bildnerndarstellt, näher und beispielhaft erläutert.

Eine sichere Rekristallisation ist in dem oberhalb der zu einer Geraden gestreckten Exponentialkurve, die die Abzisse bei einer Aufheizgeschwindigkeit $\dot{T}$ von 2 K/min und die die parallel zur Abzisse durch den Verhältniswert V = 0,8 der Ordinate laufende Gerade bei einer Aufheizgeschwindigkeit $\dot{T}$ von 7000 K/min schneidet, liegenden Bereich gewährleistet. Zur Ordinate hin ist dieser Bereich durch die parallel zur Ordinate verlaufende Gerade für die minimale Aufheizgeschwindigkeit $\dot{T}_{min}$ begrenzt, unterhalb der keine Rekristallisation stattfindet. Unterhalb der Exponentialkurve befindet sich beginnend bei der minimalen Aufheizgeschwindigkeit $\dot{T}_{min}$ ein Bereich, in dem bestimmte Zusammensetzungen von Superlegierungen durch feste legierungsabhängige Umformparameter erfolgreich rekristallisierbar sind. Dieser Bereich ist nach rechts durch eine zur Geraden gestreckte Exponentialkurve begrenzt, die die Abzisse bei einer Aufheizgeschwindigkeit $\dot{T}$ von 1000 K/min und die die parallel zur Abzisse durch den Verhältniswert V = 0,75 verlaufende Gerade bei einer Aufheizgeschwindigkeit $\dot{T}$ von 5000 K/min schneidet; rechts von dieser Exponentialkurve läßt sich eine Rekristallisation als Funktion der Aufheizgeschwindigkeit und des Verhältnisses von MC-Bildern zu $M_{23}C_6$-Bildnern nicht erreichen.

Eine weitere Erläuterung der Erfindung ergibt sich aus nachfolgenden Ausführungsbeispielen.

1. Ausführungsbeispiel

Die pulvermetallurgisch hergestellte Superlegierung der Zusammensetzung 20 Gew.-% Cr, 6 Gew.-% Al, 2 Gew.-% Mo, 3,5 Gew.-% W, 0,15 Gew.-% Zr, 0,01 Gew.-% B, < 0,05 Gew.-% C, 1,1 Gew.-% $Y_2O_3$, Rest Ni besitzt ein Verhältnis V der MC-Bildner zu den $M_{23}C_6$-Bildnern von 0,05 und ist daher nur bedingt rekristallisierbar, weil die maximale Aufheizgeschwindigkeit $\dot{T}_{max}$ für diese Legierung in den Bereich der minimalen Aufheizgeschwindigkeit $\dot{T}_{min}$ reicht.

2. Ausführungsbeispiel

Die pulvermetallurgisch hergestellte Superlegierung der Zusammensetzung 20 Gew.-% Cr, 6 Gew.-% Al, 1 Gew.-% Mo, 2 Gew.-% W, 0,15 Gew.-% Zr, 0,01 Gew.-% B, < 0,05 Gew.-% C, 1,1 Gew.-% $Y_2O_3$, Rest Ni besitzt ein Verhältnis der MC-Bildner zu den $M_{23}C_6$-Bildnern von V = 0,1. Diese Legierung weist ein unvollkommen entwickeltes Rekristallisationsgefüge bei nicht genau eingehaltenen Umformparametern und Aufheizgeschwindigkeit auf. Der kleine Bereich der Aufheizgeschwindigkeit für eine sichere Rekristallisation ist technologisch nur schwer einhaltbar.

3. Ausführungsbeispiel

Für die pulvermetallurgisch hergestellte Superlegierung der Zusammensetzung 17 Gew.-% Cr, 6 Gew.-% Al, 2 Gew.-% Mo, 3,5 Gew.-% W, 2 Gew.-% Ta, 1 Gew.-% Hf, 0,15 Gew.-% Zr, 0,01 Gew.-% B, < 0,05 Gew.-% C, 1,1 Gew.-% $Y_2O_3$, Rest Ni ergibt sich ein Verhältnis von MC-Bildnern zu $M_{23}C_6$-Bildnern von V = 0,7, so daß die maximale Aufheizgeschwindigkeit $\dot{T}_{max}$ 2000 K/min beträgt. Bei technologisch relevanten Prozessen wird eine solche Aufheizgeschwindigkeit in aller Regel nicht erreicht.

4. Ausführungsbeispiel

Die pulvermetallurgisch hergestellte Superlegierung der Zusammensetzung 15 Gew.-% Cr, 4,5 Gew.-% Al, 2,5 Gew.-% Ti, 2,0 Gew.-% Mo, 4 Gew.-% W, 2 Gew.-% Ta, 0,15 Gew.-% Zr, 0,01 Gew.-% B, < 0,05 Gew.-% C, 1,1 Gew.-% $Y_2O_3$, Rest Ni besitzt ein Verhältnis von MC-Bildnern zu $M_{23}C_6$-Bildnern von V = 1,5, so daß für alle Fälle eine vollkommene Rekristallisation erreicht wird.

5. Ausführungsbeispiel

Die Superlegierung der Zusammensetzung 17 Gew.-% Cr, 6 Gew.-% Al, 2 Gew.-% Mo, 3,5 Gew.-% W, 2 Gew.-% Ta, 0,5 Gew.-% Nb, 0,15 Gew.-% Zr, 0,01 Gew.-% B, < 0,05 Gew.-% C, 1,1 Gew.-% $Y_2O_3$, Rest Ni hat ein Verhältnis von MC-Bildnern zu $M_{23}C_6$-Bildnern von V = 0,5, so daß die maximale Aufheizgeschwindigkeit $\dot{T}_{max}$ 300 K/min beträgt und damit eine sichere Rekristallisation gewährleistet ist.

## Patentansprüche

1. Superlegierung auf Nickelbasis zur Herstellung von Profilen und Formkörpern mit einem durch Wärmebehandlung erzeugten, aus stengelförmigen Körnern gebildeten Grobgefüge, dadurch gekennzeichnet, daß die maximale Aufheizgeschwindigkeit $\dot{T}_{max}$ bis zur Rekristallisationstemperatur von dem Verhältnis V eines oder mehrerer der Metallcarbid-Bildner (MC-Bildner) Hafnium, Niob, Tantal, Titan und Zirkonium zu einem oder beiden der Metallcarbid-Bildner ($M_{23}C_6$-Bildner) Molybdän und Wolfram abhängig ist, wobei mit steigendem Verhältnis V die maximale Aufheizgeschwindigkeit $\dot{T}_{max}$ zunimmt.

2. Superlegierung nach Anspruch 1, dadurch gekennzeichnet, daß das Verhältnis V von MC-Bildnern zu $M_{23}C_6$-Bildnern

$$\frac{2{,}4\ Hf + 1{,}4\ Nb + 1{,}3\ Ta + 1{,}0\ Ti + 0{,}5\ Zr\ (At.\text{-}\%)}{Mo + W\ (At.\text{-}\%)} \geq 0{,}4$$

ist.

3. Superlegierung nach den Ansprüchen 1 und 2, dadurch gekennzeichnet, daß das Verhältnis V von MC-Bildnern zu $M_{23}C_6$-Bildnern $\geq$ 0,8 ist.

4. Superlegierung nach den Ansprüchen 1 bis 3, gekennzeichnet durch die Zusammensetzung

| 12 | bis | 25, | vorzugsweise | 17 | bis | 22 | Gew.-% Cr |
|---|---|---|---|---|---|---|---|
| 3 | bis | 8, | vorzugsweise | 4,5 | bis | 7 | Gew.-% Al |
| 0 | bis | 0,1, | vorzugsweise | 0,005 | bis | 0,05 | Gew.-% B |
| 0,01 | bis | 0,1, | vorzugsweise | 0,02 | bis | 0,07 | Gew.-% C |
| 0 | bis | 2, | vorzugsweise | 0,5 | bis | 1,5 | Gew.-% $Y_2O_3$ |
| 0 | bis | 3, | vorzugsweise | 0,2 | bis | 2 | Gew.-% Hf |
| 0 | bis | 7, | vorzugsweise | 0,5 | bis | 5 | Gew.-% Nb |
| 0 | bis | 10, | vorzugsweise | 1 | bis | 6,5 | Gew.-% Ta |
| 0 | bis | 5, | vorzugsweise | 0,5 | bis | 3,5 | Gew.-% Ti |
| 0 | bis | 1, | vorzugsweise | 0,02 | bis | 0,3 | Gew.-% Zr |
| 0 | bis | 10, | vorzugsweise | 2 | bis | 6 | Gew.-% Mo |
| 0 | bis | 7, | vorzugsweise | 1,5 | bis | 5 | Gew.-% W |
| | | | | | | | Rest Ni. |

V Verhältnis von MC- zu M$_{23}$C$_6$-Bildnern

keine Rekristallisation

Rekristallisation

Chargen-abhängige Rekristallisation

keine Rekristallisation

Aufheizgeschwindigkeit $\dot{T}$ [K/min]

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 274 631 (BBC BROWN BOVERI AG) <br> * Ansprüche 1,2 * <br> — — — | 1-4 | C 22 F 1/10 <br> C 22 C 32/00 <br> C 22 C 19/05 |
| A | EP-A-0 232 477 (BBC AKTIENGESELLSCHAFT BROWN, & CIE) <br> * Beispiel 1 * <br> — — — | 1 | |
| A | METALLURGICAL TRANSACTIONS A. PHYSICAL METAL-LURGY AND MATERIALS Bd. 18, Nr. 1, 1. Januar 1987, NEW YORK US Seiten 69 - 77; T.J.GAROSSHEN ET AL: 'Effects of B, C, and Zr on the Structure and Properties of a P/M Nickel Base Superalloy ' <br> — — — — — | | |

**RECHERCHIERTE SACHGEBIETE (Int. Cl.5)**

C 22 F
C 22 C

Der vorliegende Recherchenbericht wurde für alle Patentansprüche erstellt

| Recherchenort | Abschlußdatum der Recherche | Prüfer |
|---|---|---|
| Den Haag | 09 August 91 | GREGG N.R. |